## Europäisches Patentamt
## European Patent Office
## Office européen des brevets

(11) Publication number: **0 186 585**
**B1**

# (12) EUROPEAN PATENT SPECIFICATION

(45) Date of publication of patent specification: **06.02.91**

(51) Int. Cl.⁵: **H 01 L 23/48**

(21) Application number: **85402542.6**

(22) Date of filing: **18.12.85**

---

(54) Die bonding process.

---

(30) Priority: **19.12.84 US 683995**

(43) Date of publication of application:
**02.07.86 Bulletin 86/27**

(45) Publication of the grant of the patent:
**06.02.91 Bulletin 91/06**

(84) Designated Contracting States:
**DE FR GB IT NL**

(56) References cited:
**EP-A-0 024 572**
**EP-A-0 072 273**
**WO-A-82/02457**

(73) Proprietor: **FAIRCHILD SEMICONDUCTOR CORPORATION**
**10400 Ridgeview Court P.O. Box 1500**
**Cupertino, California 95014 (US)**

(72) Inventor: **Lawler, Harlan**
**245 Silvera Street**
**Milpitas California 94035 (US)**
Inventor: **Phy, William**
**25616 Moody Road**
**Los Altos Hills California 94002 (US)**

(74) Representative: **Sparing Röhl Henseler**
**Patentanwälte European Patent Attorneys**
**Rethelstrasse 123**
**D-4000 Düsseldorf 1 (DE)**

## Description

The present invention relates to a die bonding process as defined in the preamble of patent claim 1, and to a semiconductor device as defined in the preamble of claim 7.

Such process and device are known from WO—A—8 202 457. This document refers to a barrier layer material selected from Cr, Ti, Zr, Hf, Mo, Wo, Va, Ta, Ni.

Document EP—A—0 072 273 discloses a die bonding process in accordance with the preamble of patent claim 1 wherein the barrier layer comprises a first layer made of Cr and a second layer made of Cr—Ag.

The novel feature of the present invention is defined by the characterizing parts of claims 1 and 7, respectively.

Fig. 1 is a perspective view of a die having a barrier layer and a gold layer in accordance with the prior art.

Fig. 2 is a perspective view of an embodiment of a die according to the invention; and

Fig. 3 is a top perspective view of a package to which the die can be bonded.

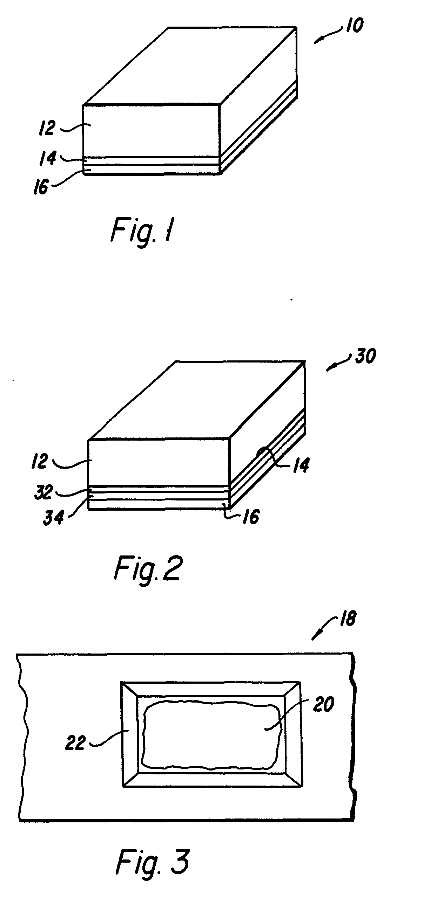

Referring to Fig. 1, a die generally referred to as 10, comprises a silicon substrate 12 having a barrier layer 14 formed over a back surface thereof. A bonding layer 16 is formed over the barrier layer 14. The barrier layer 14 comprises a refractory metal, selected from the group consisting essentially of titanium, tungsten, tantalum and niobium. The bonding layer 16 comprises a precious or noble metal, preferably gold or silver. The barrier 14 and bonding 16 layers are preferably formed as follows.

The back surface of a silicon wafer is lapped, ground or etched to obtain a substantially flat, smooth, oxide-free surface. The surface is then back sputtered to assure cleanliness before any metal is applied.

The barrier layer 14 of the refractory metal is then formed to a predetermined thickness on the back surface of the wafer utilizing a known technique such as sputtering. In a prior art embodiment, titanium is sputtered onto the back surface of the wafer to form the barrier layer 14 having a thickness preferably equal to about 50 nm (500Å). The bonding layer 16 of the precious or noble metal is then formed over the barrier layer 14 to a predetermined thickness utilizing a known technique such as sputtering. In the prior art embodiment, gold is sputtered onto the barrier layer 14 to a thickness of about 100 nm (1,000Å) to form the bonding layer 16. The back sputtering, titanium application, and gold application are done consecutively as a continuous operation. According to the invention, and as shown in Fig. 2 the barrier layer comprises a plurality of strata. Thus, the die 30 of Fig. 2 has a first stratum 32 of titanium and a second stratum 34 of tungsten. Preparation procedures for the die 30 are the same as outlined above for the above 10, except that the tungsten is sputtered onto the titanium prior to the sputtering of the gold.

Upon completion of the above steps, the wafer is diced and individual dies such as the one shown in Fig. 1 are produced. Bonding the die 10 to a package 18, as shown in Fig. 3, is preferably accomplished through employment of a solder preform 20. The solder preform 20 preferably is made of a precious metal eutectic such as gold-tin, gold-silicon, or gold-antimony. The bonding procedure involves, first of all, heating the package 18 to a predetermined temperature, for example about 305°C when using a gold-tin solder preform. The solder preform 20 is then placed at the site of proposed bondings, for example in a recess 22 as shown in Fig. 3. When the preform 20 is melted, the die 10 is placed thereon and excess preform 20 is wrung from under the die 10. The resultant assembly is then cooled, and bonding of the die 10 to the package 18 is complete.

The purpose of the barrier layer is to prevent the migration of silicon to the gold layer, both at the time of application of the gold layer to the die and at the time of bonding the die to the package. Additionally, the presence of the barrier layer requires less gold to be used for the gold layer. Further, the presence of the barrier layer enables a better eutectic bonding which can be performed at a lower temperature because no silicon can migrate to a site within the bonding composition. Thus, bonding using a gold-tin alloy solder can be carried out at a temperature of about 305°C.

It is preferred that the barrier layer be sputtered onto the back surface of the die, a process known in the art which involves the use of metal vapors which subsequently condense onto the die. Layers so applied can range in thickness from about 50 nm (500Å) to about 1000 nm (10,000Å). The barrier layer also could be applied by an evaporator, also as known in the art.

The preferred binder composition is a gold-tin alloy solder which is, of course, activated by heat. As earlier related, the solder process can be performed at a temperature below that utilized in standard processing.

As would be recognized by those having skill in the art, the process here disclosed provides many benefits. First of all, temperatures lower than those required for prior art bonding processes can be employed. Secondly, gold consumption is reduced since the amount of gold in the gold layer 16 can be reduced, as earlier described, due to prohibition of silicon migration. Thirdly, the reliability of the bond is enhanced, again due to prohibition of silicon migration. Finally, from an operational standpoint, the process is relatively simple to perform, thereby requiring no special skills on the part of an operator.

## Claims

1. A process for bonding a silicon die to a package, comprising the steps of:
   a) forming a barrier layer of a refractory metal material onto a back surface of said silicon die,
   b) forming a layer of bonding metal material over said barrier layer, and

c) bonding the die to the package by activating a binder composition disposed at the interface of the package and said bonding metal layer, characterized in that said barrier layer has one stratum of titanium and one stratum of tungsten.

2. The process of claim 1 wherein said barrier layer is sputtered onto the die back surface.

3. The process of claim 1 or claim 2 wherein said barrier layer has a thickness of about 500 nm to about 1000 nm.

4. The process of one of the preceding claims wherein said binder composition comprises a precious metal eutectic.

5. The process of claim 4 wherein said binder composition comprises a gold-tin alloy solder preform.

6. The process of claim 5 wherein said binder composition is activated by a temperature of about 305°C.

7. A semiconductor device including a bonding metal layer disposed on a back surface of a silicon die for bonding said die to a package and a refractory metal material barrier layer interposed between said die and said bonding metal layer, characterized in that said barrier layer comprises one stratum of titanium and one stratum of tungsten.

## Patentansprüche

1. Ein Verfahren zum Anheften eines Siliziumchips an eine Packung, umfassend die Schritte:

a) Bilden einer Barriereschicht aus hochtemperturfestem Metallmaterial auf einer Rückseite des Siliziumchips,

b) Bilden einer Schicht aus Haftmetallmaterial über der Barriereschicht, und

c) Anheften des Chips an die Packung durch Aktivieren einer Bindemittel-Zusammensetzung, angeordnet an der Trennstelle der Packung und der Haftmetallschicht,
dadurch gekennzeichnet, daß die Barriereschicht eine Titanlage und eine Wolframlage aufweist.

2. Das Verfahren nach Anspruch 1, bei dem die Barriereschicht auf die Chip-Rückseite aufgesputtert ist.

3. Das Verfahren nach Anspruch 1 oder Anspruch 2, bei dem die Barriereschicht eine Dicke von etwa 500 nm bis etwa 1000 nm aufweist.

4. Das Verfahren nach einem der vorangehenden Ansprüche, bei dem die Bindemittel-Zusammensetzung ein Edelmetall-Eutektikum umfaßt.

5. Das Verfahren nach Anspruch 4, bei dem die Bindemittel-Zusammensetzung eine Vorform eines Gold-Zinn-Legierungslots umfaßt.

6. Das Verfahren nach Anspruch 5, bei dem die Bindemittel-Zusammensetzung durch eine Temperatur von etwa 305°C aktiviert wird.

7. Eine Halbleiterkomponente mit einer Haftmetallschicht auf einer Rückseite eines Siliziumchips zum Anheften des Chips an eine Packung und mit einer Barriereschicht aus hochtemperaturfestem Metallmaterial, eingefügt zwischen dem Chip und der Haftmetallschicht, dadurch gekennzeichnet, daß die Barriereschicht eine Titanlage und eine Wolframlage umfaßt.

## Revendications

1. Procédé pour lier une puce en silicium à un boîtier, comprenant les étapes suivantes:

a) former une couche formant barrière d'un matériau métallique réfractaire sur une surface arrière de ladite puce en silicium,

b) former une couche d'un matériau métallique de liaison sur ladite couche formant barrière, et

c) lier la puce sur le boîtier en activant une composition formant liant, disposée à l'interface du boîtier et de ladite couche métallique de liaison, caractérisée en ce que ladite couche formant barrière a une strate de titane et une strate de tungstène.

2. Procédé selon la revendication 1, dans lequel ladite couche formant barrière est pulvérisée sur la surface arrière de la puce.

3. Procédé de la revendication 1 ou 2, dans lequel ladite couche formant barrière a une épaisseur d'environ 500 nm à environ 100 nm.

4. Procédé selon l'une des revendications précédentes, dans lequel ladite composition formant liant comporte un eutectique métallique précieux.

5. Procédé selon la revendication 4, dans lequel ladite compositon formant liant comporte un goutte de soudure en alliage or — étain.

6. Procédé selon la revendication 5, dans lequel ladite composition formant liant est activée par une température d'environ 305°C.

7. Dispositif semi-conducteur comportant une couche de métal de liaison disposée sur une surface arrière d'une puce en silicium pour lier ladite puce à un boîtier et une couche formant barrière en un matériau métallique réfractaire interposée entre ladite puce et ladite couche métallique de liaison, caractérisé en ce que ladite couche formant barrière comprend une strate de titane et une strate de tungstène.

Fig. 1

Fig. 2

Fig. 3